# EUROPEAN PATENT APPLICATION

(11) **EP 4 372 128 A1**
(43) Date of publication of application: **22.05.2024**
(21) Application number: 22841383.7
(22) Date of filing: 12.07.2022
(51) Int. Cl.: C30B 15/02, C30B 29/06

(54) **SIDE-FEEDING MONOCRYSTAL FURNACE**

(30) Priority: 15.07.2021 CN 202110800642
(71) Applicant: Longi Green Energy Technology Co., Ltd., Xi'an, Shaanxi 710100 (CN)
(72) Inventor: ZHU, Yonggang, Shaanxi 710100 (CN); ZHOU, Rui, Shaanxi 710100 (CN); LI, Qiao, Shaanxi 710100 (CN); DONG, Lin, Shaanxi 710100 (CN); ZHAO, Qunli, Shaanxi 710100 (CN); CAO, Jie, Shaanxi 710100 (CN); SHI, Shaoqiang, Shaanxi 710100 (CN); MA, Xiaokang, Shaanxi 710100 (CN)
(74) Representative: von Bülow & Tamada
(86) International application number: PCT/CN2022/105269
(87) International publication number: WO 2023/284749

(57) **Abstract**

A monocrystal furnace with lateral feeding includes: a furnace body (1), a feeding apparatus (2), and a thermal insulation layer (3), a sealing member (41), a crucible (5) and a lifting apparatus (6) that are provided within the furnace body (1). The thermal insulation layer (3) is located between the crucible (5) and the furnace body (1), a first through-hole (11) is provided on a side portion of the furnace body (1), and a second through-hole (32) is provided in a position opposite to the first through-hole (11) on the thermal insulation layer (3); the lifting apparatus (6) is connected to the sealing member (41) and is used to drive the sealing member (41) to switch between a rising state and a falling state.

## Description

The present application claims the priority of the Chinese patent application filed on July 15th, 2021, before the CNIPA, China National Intellectual Property Administration, with the application number of 202110800642.X and the title of "MONOCRYSTAL FURNACE WITH LATERAL FEEDING", which is incorporated herein in its entirety by reference.

### FIELD

The present application relates to the technical field of monocrystal manufacturing equipment and more particularly, to a monocrystal furnace with lateral feeding.

### BACKGROUND

With the development of the photovoltaic industry, the competition of the crystalline silicon industry in China is increasing. Currently, in order to reduce the cost of monocrystal manufacturing, the industry has begun to develop the monocrystal furnace with lateral feeding, i.e., feeding from the side portion of the monocrystal furnace, to improve the loss of thermal energy due to feeding and to reduce the impact of the original high-altitude drop feeding on the thermal field life. In practice, the feeding apparatus is usually arranged at a side of the monocrystal furnace, i.e., it is necessary to provide through-holes at sides of the furnace barrel and the thermal field insulation layer of the monocrystal furnace, to allow the feeding apparatus to feed into the furnace barrel through the through-hole.

However, providing through-holes at the sides of the furnace barrel and the thermal insulation layer would easily lead to serious heat leakage at the position where the through-holes are located, increasing the power consumption of the monocrystal furnace. Moreover, it is easy to break the balance of temperature field and airflow in the monocrystal furnace and reduce the crystal pulling efficiency and quality of monocrystalline silicon.

### SUMMARY

In view of the foregoing, embodiments of the present application provide a monocrystal furnace with lateral feeding to overcome, or at least partially solve, the foregoing problems.

In order to solve the above problems, embodiments of the present application disclose a monocrystal furnace with lateral feeding including a furnace body, a feeding apparatus, and a thermal insulation layer, a sealing member, a crucible and a lifting apparatus that are provided within the furnace body, wherein the thermal insulation layer is located between the crucible and the furnace body;
a first through-hole is provided on a side portion of the furnace body, and a second through-hole is provided in a position of the thermal insulation layer opposite to the first through-hole; and
the lifting apparatus is connected to the sealing member and is used to drive the sealing member to switch between a rising state and a falling state; in the rising state, the sealing member rises, and the feeding apparatus is capable of passing through the first through-hole and the second through-hole to be opposite to an opening of the crucible; and in the falling state, the sealing member falls, and the sealing member is capable of sealing the second through-hole.

Optionally, the monocrystal furnace further includes a protection barrel embedded in the second through-hole; and
the protection barrel is provided with a third through-hole for penetrating the feeding apparatus.

Optionally, the monocrystal furnace includes a hanger with a flexible feature, one end of the hanger is connected to the lifting apparatus, and the other end of the hanger is used for hanging the sealing member.

Optionally, a counterweight is further provided in the monocrystal furnace, and the counterweight is installed at one end of the sealing member connected to the hanger.

Optionally, a first inclined plane structure is provided at a position of the thermal insulation layer opposite to the sealing member, and a second inclined plane structure is provided at a position of the sealing member opposite to the thermal insulation layer; and
under the condition that the lifting apparatus drives the sealing member to switch to the falling state, the first inclined plane structure and the second inclined plane structure are fitted.

Optionally, the first inclined plane structure includes a first sub-inclined plane structure and a second sub-inclined plane structure, wherein the second through-hole is provided between the first sub-inclined plane structure and the second sub-inclined plane structure; and
under the condition that the lifting apparatus drives the sealing member to switch to the falling state, both the first sub-inclined plane structure and the second sub-inclined plane structure are fitted with the second inclined plane structure.

Optionally, a first included angle between the first inclined plane structure and an axis of the thermal insulation layer is 5-15°, and a second included angle between the second inclined plane structure and the axis of the thermal insulation layer is 75-85°.

Optionally, the feeding apparatus further includes a feeding valve connected to the first through-hole and the feeding apparatus, respectively; and
the feeding valve is opened, and the feeding apparatus is capable of passing through the first through-hole and the second through-hole to be opposite to the opening of the crucible.

Optionally, the feeding apparatus includes a feeding mechanism and a telescopic tube, wherein the feeding mechanism is connected to the telescopic tube, and the telescopic tube is connected to the feeding valve; and
the telescopic tube includes a compressed state and an expansion state, and under the condition that the telescopic tube is switched to the compressed state, the feeding mechanism is capable of being driven to pass through the first through-hole and the second through-hole to be opposite to the opening of the crucible.

Optionally, the lifting apparatus includes a driving mechanism and a lifting mechanism; wherein the driving mechanism is provided in the furnace body, the driving mechanism is connected to the lifting mechanism, and the lifting mechanism is connected to the sealing member; and
the driving mechanism is configured to drive the lifting mechanism to rise or fall, and rising or falling of the lifting mechanism drives the sealing member to switch between the rising state and the falling state.

Optionally, the monocrystal furnace further includes a heat exchange mechanism, the heat exchange mechanism is provided above the crucible, the lifting apparatus is connected to the heat exchange mechanism, and the heat exchange mechanism is connected to the sealing member; and
the lifting apparatus is configured to drive the heat exchange mechanism to rise or fall, and rising or falling of the heat exchange mechanism drives the sealing member to switch between the rising state and the falling state.

The embodiments of the present application include the following advantages:

In the embodiments of the present application, the lifting apparatus may drive the sealing member to switch to the rising state, so that the feeding apparatus may pass through the first through-hole on the side portion of the furnace body and the second through-hole on the thermal insulation layer to be opposite to the opening of the crucible, so as to realize the lateral feeding of the monocrystal furnace, and may improve the effect of high-altitude drop feeding on the thermal field life. Furthermore, the lifting apparatus may also drive the sealing member to switch to a falling state, so that the sealing member may block and protect the second through-hole on the thermal insulation layer, which may improve the thermal field life, reduce the heat energy loss in non-feeding conditions, stabilize the temperature field and airflow balance within the furnace body of the monocrystal furnace, reduce the probability of breaking wires and growing polycrystal, and improve the crystal pulling efficiency and quality of monocrystalline silicon.

### BRIEF DESCRIPTION OF THE DRAWINGS

FIG. 1 is a schematic structural diagram of a monocrystal furnace according to the present application;
FIG. 2 is a schematic structural diagram of another monocrystal furnace of the present application;
FIG. 3 is a schematic structural diagram of still another monocrystal furnace according to the present application; and
FIG. 4 is a schematic structural diagram of yet still another monocrystal furnace according to the present application;

### Reference numbers:

1-furnace body, 11-first through-hole, 2-feeding apparatus, 21-feeding valve, 22-feeding mechanism, 23-telescopic tube, 3-thermal insulation layer, 31-first inclined plane structure, 311-first sub-inclined plane structure, 312-second sub-inclined plane structure, 32-second through-hole, 41-sealing member, 411-second inclined plane structure, 42-counterweight, 5-crucible, 6-lifting apparatus, 7-protection barrel, 71-third through-hole, 81-hanger, 82-rigid connecting plate, 9-heat exchange mechanism.

### DETAILED DESCRIPTION

In order to make the above objectives, features, and advantages of the present application more obvious and understandable, the present application will be further described in detail below with reference to the accompanying drawings and specific embodiments.

One of the core concepts of the embodiments of the present application is to provide a monocrystal furnace with lateral feeding.

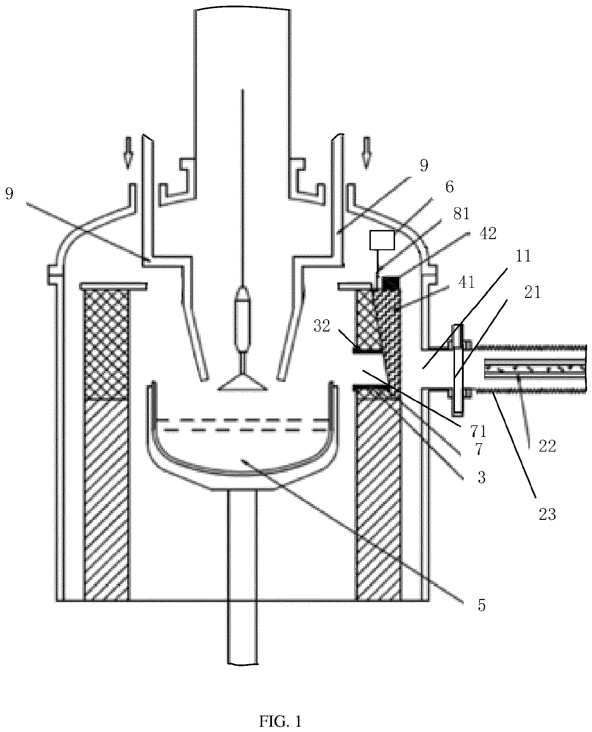

Referring to FIG. 1, a schematic structural diagram of a monocrystal furnace of the present application is shown. As shown in FIG. 1, the present application provides a monocrystal furnace with lateral feeding, which may specifically include a furnace body 1, a feeding apparatus 2, and a thermal insulation layer 3, a sealing member 41, a crucible 5, and a lifting apparatus 6 that are provided within the furnace body 1. The thermal insulation layer 3 is located between the crucible 5 and the furnace body 1. A first through-hole 11 is provided on a side portion of the furnace body 1, and a second through-hole 32 is provided in a position of the thermal insulation layer 3 opposite to the first through-hole 11. The lifting apparatus 6 is connected to the sealing member 41 and is used to drive the sealing member 41 to switch between a rising state and a falling state. In the rising state, the sealing member 41 rises, and the feeding apparatus 2 may pass through the first through-hole 11 and the second through-hole 32 to be opposite to an opening of the crucible 5. In the falling state, the sealing member 41 falls, and the sealing member 41 may seal the second through-hole 32.

In the embodiment of the present application, the lifting apparatus 6 may drive the sealing member 41 to switch to the rising state, so that the feeding apparatus 2 may pass through the first through-hole 11 on the side portion of the furnace body 1 and the second through-hole 32 on the thermal insulation layer 3 to be opposite to the opening of the crucible 5, so as to realize the lateral feeding of the monocrystal furnace, and may improve the effect of high-altitude drop feeding on the thermal field life. Furthermore, the lifting apparatus 6 may also be switched to a falling state, and the sealing member 41 may fall, so that the sealing member 41 may block and protect the second through-hole 32 on the thermal insulation layer 3, so as to improve the thermal field life, reduce the heat energy loss in non-feeding conditions, stabilize the temperature field and airflow balance within the furnace body 1 of the monocrystal furnace, reduce the probability of breaking wires and growing polycrystal, and improve the crystal pulling efficiency and quality of monocrystalline silicon.

Specifically, the first through-hole 11 is provided on the side portion of the furnace body 1, and the feeding apparatus 2 is also provided on the side portion of the furnace body 1, so that the feeding apparatus 2 may feed into the crucible 5 from the side portion of the furnace body 1, which may reduce the loss of thermal energy during the process of stopping the feeding. It may also avoid the impact of high-altitude drop feeding on the thermal field life. Furthermore, the feeding apparatus 2 is provided at the side portion of the furnace body 1, so as to break the limit on the feeding weight, save the feeding time and reduce the number of feeding workers.

In practical applications, the power consumption of the monocrystal furnace in the embodiment of the present application may be reduced by more than 60% as compared with a monocrystal furnace in the prior art which is not provided with a sealing member 41 for blocking the second through-hole 32 of the thermal insulation layer 3.

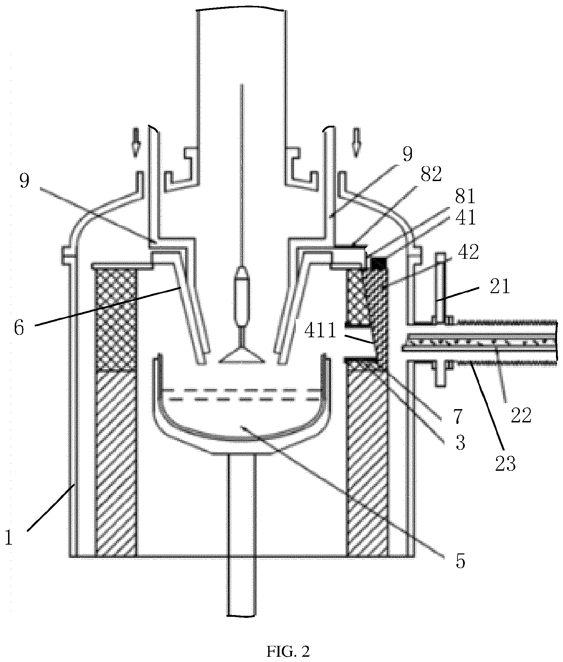

As shown in FIG. 1, the lifting apparatus 6 drives the sealing member 41 to switch to the rising state, the sealing member 41 rises, and the second through-hole 32 is opened. The feeding apparatus 2 may pass through the first through-hole 11 and the second through-hole 32 and add raw materials into the crucible 5. As shown in FIG. 2, after the feeding is completed, the lifting apparatus 6 may drive the sealing member 41 to switch to the falling state, and the sealing member 41 may be closely fitted with the thermal insulation layer 3 and block the second through-hole 32.

The monocrystal furnace in the embodiments of the present application is equipment for growing a monocrystal by the Czochralski process using a heater to melt a polycrystalline material in an inert gas (nitrogen, helium mainly) environment. The furnace body 1 in the embodiment of the present application is an equipment body of a monocrystal furnace and is used for mounting and connecting the thermal insulation layer 3, the sealing member 41, the crucible 5, the lifting apparatus 6, and the feeding apparatus 2.

The feeding apparatus 2 in the embodiment of the present application is an apparatus for storing raw materials and for feeding the raw materials into the crucible 5.

The crucible 5 in the embodiments of the present application, as an important component of a chemical instrument, is a container capable of melting and refining a metal liquid as well as solid-liquid heating and reaction and is the basis for ensuring the smooth progress of a chemical reaction. Specifically, in the present embodiment, the crucible 5 is a container for melting raw materials and growing monocrystalline silicon.

The thermal insulation layer 3 in the embodiment of the present application may be an insulating interlayer used between the furnace body 1 and the heater in a monocrystal furnace. The heater may be used to heat the material in the crucible 5. The thermal insulation layer 3 may be positioned between the crucible 5 and the furnace body 1 to prevent heat loss and stabilize the growth environment of the monocrystalline silicon. Specifically, the thermal insulation layer 3 may be thermal insulation felt having many advantages, such as high thermal insulation rate, windproof, rainproof, snow proof, anti-aging, flame retardant, high moisture resistance, dustproof, moisture-proof, acid and alkali resistant, easy to store, and long service life.

The sealing member 41 in the embodiment of the present application may be used to seal the thermal insulation layer 3 to further improve the thermal insulation effect of the thermal insulation layer 3.

Specifically, both the thermal insulation layer 3 and the sealing member 41 may be an insulating material member. In practical applications, both the thermal insulation layer 3 and the sealing member 41 are insulating materials, which may reduce heat dissipation and improve the crystal pulling speed of the monocrystalline silicon.

Specifically, the material of the thermal insulation layer 3 and the sealing member 41 may be a graphite soft felt, a cured carbon felt, etc. which is not specifically limited by the embodiments of the present application.

The lifting apparatus 6 in the embodiment of the present application may bring the sealing member 41 to rise or fall. Specifically, the lifting apparatus 6 may include a drive motor, which may provide motive force. The drive motor may be connected to the sealing member 41 to directly drive the sealing member 41 to rise or fall.

In practical applications, the furnace body 1 is also provided with a heat shielding apparatus, which may be a structural component in the monocrystal furnace that is designed to meet the process requirements of interlayer water flow. The heat shielding apparatus may include a water pipe which may include a water inlet pipe and a water outlet pipe, and the hardness of the water inlet pipe and the water outlet pipe are relatively high. The lifting apparatus 6 may be connected to a water pipe and drive the heat shielding apparatus to rise or fall, and the heat shielding apparatus may be a heat exchanger or a heat shield.

Specifically, the sealing member 41 may also be connected to a water pipe, so that the driving motor may also drive the sealing member 41 to rise or fall through the water pipe, which is not specifically limited by the embodiments of the present application.

Specifically, the structure of the first through-hole 11 and the second through-hole 32 may be circular, quadrangular, pentagonal, or hexagonal, etc. which is not specifically limited by the embodiments of the present application.

In some embodiments of the present application, the monocrystal furnace may further include a protection barrel 7. The protection barrel 7 may be embedded in the second through-hole 32. The protection barrel 7 may be provided with a third through-hole 71 which may be used to penetrate the feeding apparatus 2.

In the embodiment of the present application, the protection barrel 7 is embedded in the second through-hole 32 and is provided with a third through-hole 71, so that the feeding apparatus 2 may sequentially feed into the crucible 5 through the first through-hole 11 and the third through-hole 71. In practical applications, the third through-hole 71 may be flushed by the airflow, so that the protection barrel 7 may protect the thermal insulation layer 3, so as to alleviate the atomization phenomenon caused by the airflow flushing on the thermal insulation layer 3 and improve the service life of the thermal insulation layer 3.

Specifically, the furnace body 1 may be purged with an inert gas before feeding into the crucible 5, the inert gas under pressure may enter the furnace body 1 from the first through-hole 11, and perform high-temperature airflow flushing on the third through-hole 71 of the protection barrel 7. In the process of pulling monocrystalline silicon, the inert gas may also drive volatiles out of the furnace body 1, and the inert gas may also perform a high-temperature airflow flushing on the third through-hole 71 of the protection barrel 7. In the embodiment of the present application, the protection barrel 7 is embedded in the second through-hole 32 of the thermal insulation layer 3, so as to protect the thermal insulation layer 3 from being washed by a high-temperature airflow, thereby preventing the thermal insulation layer 3 from powdering at the second through-hole 32 and improving the service life of the thermal insulation layer 3.

In practical applications, the protection barrel 7 may better protect the thermal insulation layer 3. Compared with the thermal insulation layer 3 without the second through-hole 32, the thermal insulation layer 3 in the embodiments of the present application may have a substantially same service life compared with the thermal insulation layer 3 without the second through-hole 32 in the prior art.

Specifically, the material of the protection barrel 7 includes at least one of graphite and carbon-carbon composite material. In practical applications, selecting graphite or carbon-carbon composite material for the protection barrel 7 may improve the protective effect of the protection barrel 7 on the thermal insulation layer 3 and further improve the service life of the thermal insulation layer 3.

Specifically, the outer side of the protection barrel 7 may be connected in the second through-hole 32 of the thermal insulation layer 3, and the structure of the outer side of the protection barrel 7 is adapted to the structure of the second through-hole 32. For example, the structure of the second through-hole 32 is circular, and the structure of the outer side of the protection barrel 7 is also circular; the structure of the second through-hole 32 is pentagonal, and the structure of the outer side of the protection barrel 7 is also pentagonal.

Specifically, the structure of the third through-hole 71 may be circular, quadrangular, pentagonal, or hexagonal, etc. which is not specifically limited by the embodiments of the present application.

Optionally, the monocrystal furnace may include a hanger 81 with a flexible feature. One end of the hanger 81 may be connected to the lifting apparatus 6, and the other end of the hanger 81 may be used for hanging the sealing member 41.

Specifically, the flexible feature refers to a feature in which an object may undergo any deformation under the action of a force, and when the force disappears, the deformation may be maintained, which may also be interpreted as a property of the object that is flexible or in terms of rigidity. Flexibility refers to a physical property that an object is deformed after being subjected to a force, and the object itself cannot recover its original shape after the force is lost. However, when a rigid object is subjected to a force, the shape of the rigid object may be regarded as not changing macroscopically.

In the embodiment of the present application, a hanger 81 with the flexible feature is used to hang the sealing member 41, and in the falling state, the sealing member 41 may be fitted with the thermal insulation layer 3 by means of its own gravity, thereby sealing the second through-hole 32 of the thermal insulation layer 3, and improving the sealing effect.

Specifically, the hanger 81 has the flexible feature, which is guided freely mainly by the structure of the hanged object and by the action of its own weight. Specifically, the hanger 81 may be bent at will, and the path of movement of lifting the sealing member 41 may be varied at will. Under the condition that the hanger 81 is lowered to the limit position, the hanger 81 may not apply any force to the sealing member 41. The hanger 81 may include a flexible rope, a chain, etc. which is not specifically limited by the embodiments of the present application.

Specifically, the hanger 81 may also be used in combination with a rigid connecting plate 82. One end of the rigid connecting plate 82 may be connected to a water pipe, and the hanger 81 may be connected to the other end of the rigid connecting plate 82, as shown in FIG. 1.

As shown in FIG. 1, the lifting apparatus 6 drives the sealing member 41 to switch to the rising state, the sealing member 41 rises, and the second through-hole 32 is opened. The feeding apparatus 2 may pass through the first through-hole 11 and the second through-hole 32 and feed raw materials into the crucible 5. As shown in FIG. 2, after the feeding is completed, the lifting apparatus 6 may be switched to the falling state, the sealing member 41 is closely fitted with the thermal insulation layer 3 under the action of gravity, and slides downwards. When the sealing member 41 descends to a lower limit, the lifting apparatus 6 may continue to descend, the hanger 81 may be in a relaxed state, and the sealing member 41 may be in close contact with the thermal insulation layer 3, so as to achieve the purpose of blocking the second through-hole 32.

Optionally, a counterweight 42 may be provided in the monocrystal furnace, and the counterweight 42 may be installed at one end of the sealing member 41 connected to the hanger 81.

In the embodiment of the present application, the weight of the sealing member 41 may be increased by installing the counterweight 42 at the end where the sealing member 41 is connected to the hanger 81, thereby further improving the sealing effect of the sealing member 41 on the second through-hole 32 of the thermal insulation layer 3.

Specifically, the counterweight 42 is a weight that may increase the self-weight of the sealing member 41 and maintain balance. The counterweight 42 may include a common sand mold counterweight iron or extra heavy iron, etc. which may be specifically set according to practical requirements and is not specifically limited by the embodiments of the present application.

In other embodiments of the present application, a first inclined plane structure 31 may be provided at a position of the thermal insulation layer 3 opposite to the sealing member 41, and a second inclined plane structure 411 may be provided at a position of the sealing member 41 opposite to the thermal insulation layer 3. The first inclined plane structure 31 and the second inclined plane structure 411 may be fitted under the condition that the sealing member 41 is switched to the falling state by the lifting apparatus 6.

In the embodiment of the present application, the position of the thermal insulation layer 3 opposite to the sealing member 41 is the first inclined plane structure 31, and the position of the sealing member 41 opposite to the thermal insulation layer 3 is the second inclined plane structure 411. In this way, when the sealing member 41 is fitted with the thermal insulation layer 3 by means of its own gravity, the tightness of the fitting is better, and the sealing effect of the sealing member 41 on the second through-hole 32 of the thermal insulation layer 3 may be further improved.

Specifically, the shapes of the first inclined plane structure 31 and the second inclined plane structure 411 are adapted. For example, the first inclined plane structure 31 includes a plurality of protrusions, and the second inclined plane structure 411 is provided with a plurality of grooves at positions opposite to the protrusions. The first inclined plane structure 31 includes a plurality of grooves, and the second inclined plane structure 411 is provided with a plurality of projections at positions opposite to the projections. The first inclined plane structure 31 is a planar structure, and the second inclined plane structure 411 may also be a planar structure. The specific arrangement of the first inclined plane structure 31 and the second inclined plane structure 411 may be set according to actual requirements, which is not specifically limited by the embodiments of the present application.

Specifically, the first inclined plane structure 31 may be an integral structure, and the second through-hole 32 may be a through-hole opened on the first inclined plane structure 31. Alternatively, the first inclined plane structure 31 may be a structural assembly composed by a plurality of split structures, and the second through-hole 32 may be provided between the plurality of split structures, which is not specifically defined in the embodiments of the present application.

Optionally, the first inclined plane structure 31 may include a first sub-inclined plane structure 311 and a second sub-inclined plane structure 312, and a second through-hole 32 may be provided between the first sub-inclined plane structure 311 and the second sub-inclined plane structure 312. Under the condition that the lifting apparatus 6 drives the sealing member 41 to switch to the falling state, both the first sub-inclined plane structure 311 and the second sub-inclined plane structure 312 may be fitted with the second inclined plane structure.

In the embodiment of the present application, under the condition that the lifting apparatus 6 drives the sealing member 41 to switch to the falling state, both the first sub-inclined plane structure 311 and the second sub-inclined plane structure 312 are fitted with the second inclined plane structure. Since the second through-hole 32 is provided between the first sub-inclined plane structure 311 and the second sub-inclined plane structure 312, the sealing member 41 may seal the second through-hole 32 and reduce heat dissipation.

Optionally, the first included angle between the first inclined plane structure 31 and the axis of the thermal insulation layer 3 may be 5-15°, and the second included angle between the second inclined plane structure 411 and the axis of the thermal insulation layer 3 may be 75-85°.

In the embodiment of the present application, the first included angle is 5-15°, and the second included angle may be 75-85°, so that the sealing member 41 has a better fitting effect with the thermal insulation layer 3.

Specifically, the first included angle may be 4°, 5°, 10°, 15°, 20°, etc. and the second included angle may be 70°, 75°, 80°, 85°, 90°, etc., which may be specifically set according to practical requirements and is not specifically limited by the embodiments of the present application.

Specifically, under the condition that the first included angle is 0° and the second included angle is 90°, the first inclined plane structure 31 and the second inclined plane structure 32 are arranged in parallel, so that the sealing member 41 may block the second through-hole 32 of the thermal insulation layer 3 on the straight side. In this case, the hanger 81 may be respectively connected to the lifting apparatus and the sealing member 41, so that the hanger 81 drives the sealing member 41 to rise or fall. It is also possible to connect the lifting apparatus and the sealing member 41 respectively with a rigid hanger, so that the rigid hanger may drive the sealing member 41 to rise or fall.

In practical applications, the first included angle is 5-15° and the second included angle is 75-85°, and using a hanger 81 to hang the sealing member 41 may reduce consumption by about 20% compared with the sealing member 41 directly blocking the second through-hole 32 of the thermal insulation layer 3 and using a rigid hanger to connect the sealing member 41.

Optionally, the feeding apparatus 2 may further include a feeding valve 21, which may be connected to the first through-hole 11 and the feeding apparatus 2, respectively. The feeding valve 21 is opened, and the feeding apparatus 2 may pass through the first through-hole 11 and the second through-hole 32 to be opposite to an opening of the crucible 5.

In the embodiment of the present application, the feeding valve 21 is respectively connected to the first through-hole 11 and the feeding apparatus 2. Under the condition that feeding is required, the feeding valve 21 may be opened, and the feeding apparatus 2 may pass through the first through-hole 11 and the second through-hole 32 to be opposite to the opening of the crucible 5, and feeding into the crucible 5. In non-feeding conditions, the feeding valve 21 may be closed, effectively isolating the feeding apparatus 2 from the furnace body 1.

Specifically, the feeding valve 21 may be an electrically controlled valve or a manual valve, which is not specifically limited by the embodiments of the present application. As shown in FIG. 1, a manual valve is shown.

Optionally, the feeding apparatus 2 may include a feeding mechanism 22 and a telescopic tube 23. The feeding mechanism 22 may be connected to the telescopic tube 23, and the telescopic tube 23 may be connected to the feeding valve 21. The telescopic tube 23 may include a compressed state and an expansion state, and under the condition that the telescopic tube 23 is switched to the compressed state, the feeding mechanism 22 may be driven to pass through the first through-hole 11 and the second through-hole 32 to be opposite to the opening of the crucible 5.

In the embodiment of the present application, under the condition that the telescopic tube 23 is switched to the compressed state, the telescopic tube 23 may drive the feeding mechanism 22 to pass through the first through-hole 11 and the second through-hole 32 to be opposite to the opening of the crucible 5, so that the feeding mechanism 22 may introduce raw materials into the crucible 5, which makes feeding more convenient and faster.

Specifically, the telescopic tube 23 may be a corrugated tube, or the telescopic tube 23 may also be a casing pipe formed by sleeving a plurality of tubes, which may be specifically provided according to practical requirements and is not specifically limited by the embodiments of the present application.

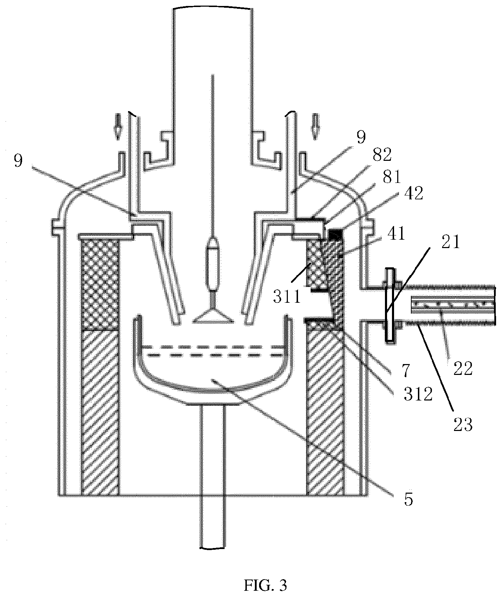

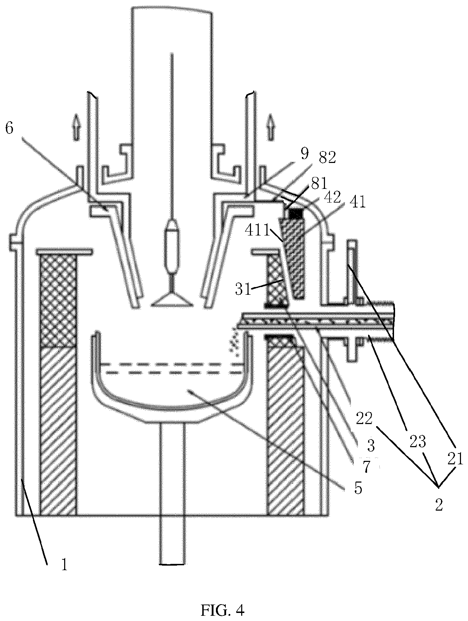

Specifically, as shown in FIG. 4, the telescopic tube 23 is switched from the expansion state to the compressed state, and the feeding mechanism 22 may sequentially pass through the feeding valve 21, the first through-hole 11, and the third through-hole 71 from the original position, and deliver the raw material into the crucible 5. As shown in FIG. 2, after the feeding is completed, the telescopic tube 23 is gradually expanded. Under the condition that the feeding apparatus 2 is withdrawn from the second through-hole 32, the sealing member 41 may be immediately lowered to seal the second through-hole 32. As shown in FIG. 3, the telescopic tube 23 is switched from the telescopic state to the expansion state, the feeding mechanism 22 may be retracted to the original position, and the feeding valve 21 may be closed.

In some alternative embodiments of the present application, the lifting apparatus 6 may include a driving mechanism and a lifting mechanism. The driving mechanism may be provided in the furnace body 1, the driving mechanism may be connected to the lifting mechanism, and the lifting mechanism may be connected to the sealing member 41. The driving mechanism may be used to drive the lifting mechanism to rise or fall, which may cause the sealing member 41 to switch between the rising state and the falling state.

In the embodiment of the present application, by providing a special driving mechanism and a lifting mechanism, the sealing member 41 may be switched between the rising state and the falling state, improving the ease of using the sealing member 41.

Specifically, the lifting apparatus 6 may be provided close to the sealing member 41, and as shown in FIG. 1, the lifting apparatus 6 may also be provided above the sealing member 41, which is not specifically limited by the embodiments of the present application.

In still other alternative embodiments of the present application, as shown in FIG. 2, the monocrystal furnace may include a heat exchange mechanism 9. The heat exchange mechanism 9 may be provided above the crucible 5, the lifting apparatus 6 is connected to the heat exchange mechanism 9, and the heat exchange mechanism 9 is connected to the sealing member 41. The lifting apparatus 6 is used to drive the heat exchange mechanism 9 to rise or fall. The rising or falling of the heat exchange mechanism 9 drives the sealing member 41 to switch between the rising state and the falling state.

In the implementation of the present application, the lifting apparatus 6 may drive the heat exchange mechanism 9 to rise or fall, and the rising or falling of the heat exchange mechanism 9 may drive the sealing member 41 to switch between a rising state and a falling state, so that the heat exchange mechanism 9 and the sealing member 41 may share one lifting apparatus 6, which may save the arrangement space and cost of the monocrystal furnace.

Specifically, the heat exchange means 9 may be a heat shielding apparatus.

The monocrystal furnace with lateral feeding provided by embodiments of the present application include at least the following advantages:
In the embodiments of the present application, the lifting apparatus may drive the sealing member to switch to the rising state, so that the feeding apparatus may pass through the first through-hole on the side portion of the furnace body and the second through-hole on the thermal insulation layer to be opposite to the opening of the crucible, so as to realize the lateral feeding of the monocrystal furnace, and may improve the effect of high-altitude drop feeding on the thermal field life. Furthermore, the lifting apparatus may also drive the sealing member to switch to the falling state, so that the sealing member may block and protect the second through-hole on the thermal insulation layer, which may improve the thermal field life, reduce the heat energy loss in non-feeding conditions, stabilize the temperature field and airflow balance within the furnace body of the monocrystal furnace, reduce the probability of breaking wires and growing polycrystal, and improve the crystal pulling efficiency and quality of monocrystalline silicon.

It is noted that embodiments of the present application are not limited by the order of actions described, as some steps may occur in other orders or concurrently according to embodiments of the present application. Secondly, a person skilled in the art would also know that the embodiments described in the description are all preferred embodiments, and the actions involved are not necessarily required by the embodiments of the present application.

Various embodiments are described in the description in a progressive manner. Each embodiment focuses on the differences from other embodiments, and the same and similar parts between the various embodiments may be referred to as each other.

While preferred embodiments of the detailed description have been described, additional variations and modifications to these embodiments will occur to those skilled in the art once the basic inventive concept is known. Therefore, it is intended that the appended claims be interpreted as including the preferred embodiments and all alterations and modifications that fall within the scope of the detailed description of the present application.

Finally, it should be noted that relational terms herein such as "first" and "second", and the like, are used solely to distinguish one entity or operation from another entity or operation without necessarily requiring or implying any actual such relationship or order between such entities or operations. Further, the terms "include", "comprise", or any other variation thereof are intended to cover nonexclusive inclusion, so that a process, method, item, or end device that includes a series of elements not only includes those elements, but also other elements that are not explicitly listed, or also include elements inherent in such a process, method, item, or end device. An element proceeded by the sentence "comprises one", does not, without more constraints, preclude the existence of additional identical elements in the process, method, article, or terminal device that comprises the element.

The above provides a detailed introduction to a monocrystal furnace with lateral feeding provided in the present application. Specific examples are applied herein to explain the principles and implementation methods of the present application. The above examples are only used to help understand the methods and core ideas of the present application. Meanwhile, for general technical personnel in this field, there may be changes in specific implementation methods and application scope based on the ideas of the present application. In summary, the content of this specification should not be understood as a limitation of the present application.

## Claims

1. A monocrystal furnace with lateral feeding, **characterized in that** the monocrystal furnace comprises a furnace body, a feeding apparatus, and a thermal insulation layer, a sealing member, a crucible and a lifting apparatus that are provided within the furnace body, and the thermal insulation layer is located between the crucible and the furnace body;
a first through-hole is provided on a side portion of the furnace body, and a second through-hole is provided in a position of the thermal insulation layer opposite to the first through-hole; and
the lifting apparatus is connected to the sealing member and is used to drive the sealing member to switch between a rising state and a falling state; in the rising state, the sealing member rises, and the feeding apparatus is capable of passing through the first through-hole and the second through-hole to be opposite to an opening of the crucible; and in the falling state, the sealing member falls, and the sealing member is capable of sealing the second through-hole.

2. The monocrystal furnace according to claim 1, **characterized in that** the monocrystal furnace further comprises a protection barrel embedded in the second through-hole; and
the protection barrel is provided with a third through-hole for penetrating the feeding apparatus.

3. The monocrystal furnace according to claim 1, **characterized in that** the monocrystal furnace comprises a hanger with a flexible feature, one end of the hanger is connected to the lifting apparatus, and the other end of the hanger is used for hanging the sealing member.

4. The monocrystal furnace according to claim 3, **characterized in that** a counterweight is further provided in the monocrystal furnace, and the counterweight is installed at one end of the sealing member connected to the hanger.

5. The monocrystal furnace according to claim 1, **characterized in that** a first inclined plane structure is provided at a position of the thermal insulation layer opposite to the sealing member, and a second inclined plane structure is provided at a position of the sealing member opposite to the thermal insulation layer; and
under the condition that the lifting apparatus drives the sealing member to switch to the falling state, the first inclined plane structure and the second inclined plane structure are fitted.

6. The monocrystal furnace according to claim 5, **characterized in that** the first inclined plane structure comprises: a first sub-inclined plane structure and a second sub-inclined plane structure, wherein the second through-hole is provided between the first sub-inclined plane structure and the second sub-inclined plane structure; and
under the condition that the lifting apparatus drives the sealing member to switch to the falling state, both the first sub-inclined plane structure and the second sub-inclined plane structure are fitted with the second inclined plane structure.

7. The monocrystal furnace according to claim 5, **characterized in that** a first included angle between the first inclined plane structure and an axis of the thermal insulation layer is 5-15°, and a second included angle between the second inclined plane structure and the axis of the thermal insulation layer is 75-85°.

8. The monocrystal furnace according to claim 1, **characterized in that** the feeding apparatus further comprises a feeding valve connected to the first through-hole and the feeding apparatus, respectively; and
the feeding valve is opened, and the feeding apparatus is capable of passing through the first through-hole and the second through-hole to be opposite to the opening of the crucible.

9. The monocrystal furnace according to claim 8, **characterized in that** the feeding apparatus comprises a feeding mechanism and a telescopic tube, the feeding mechanism is connected to the telescopic tube, and the telescopic tube is connected to the feeding valve; and
the telescopic tube comprises a compressed state and an expansion state, and under the condition that the telescopic tube is switched to the compressed state, the feeding mechanism is capable of being driven to pass through the first through-hole and the second through-hole to be opposite to the opening of the crucible.

10. The monocrystal furnace according to claim 1, **characterized in that** the lifting apparatus comprises a driving mechanism and a lifting mechanism, the driving mechanism is provided in the furnace body, the driving mechanism is connected to the lifting mechanism, and the lifting mechanism is connected to the sealing member; and
the driving mechanism is configured to drive the lifting mechanism to rise or fall, and rising or falling of the lifting mechanism drives the sealing member to switch between the rising state and the falling state.

11. The monocrystal furnace according to claim 1, **characterized in that** the monocrystal furnace further comprises a heat exchange mechanism, the heat exchange mechanism is provided above the crucible, the lifting apparatus is connected to the heat exchange mechanism, and the heat exchange mechanism is connected to the sealing member; and
the lifting apparatus is configured to drive the heat exchange mechanism to rise or fall, and rising or falling of the heat exchange mechanism drives the sealing member to switch between the rising state and the falling state.
